# EUROPEAN PATENT APPLICATION

(11) **EP 4 270 664 A1**
(43) Date of publication of application: **01.11.2023**
(21) Application number: 23169888.7
(22) Date of filing: 25.04.2023
(51) Int. Cl.: H01R 4/38, H02G 5/00, H01R 13/66

(54) **PLUG-IN DEVICE AND POWER CONVERSION APPARATUS**

(30) Priority: 26.04.2022 CN 202220984021 U
(71) Applicant: Sungrow Power Supply Co., Ltd., Hefei, Anhui 230088 (CN)
(72) Inventor: WU, Zhengwei, Heifei, 230088 (CN); WANG, Xiaohu, Heifei, 230088 (CN); ZHENG, Hao, Heifei, 230088 (CN); DU, Zelin, Heifei, 230088 (CN)
(74) Representative: Zacco Norway AS

(57) **Abstract**

A plug-in device and a power conversion apparatus are provided. The plug-in device includes a housing, a connector and a temperature acquisition device. The housing is defined with a holding cavity. The connector includes a clamping part and a fixed connection part. The clamping part is arranged in the holding cavity. The fixed connection part partially extends out of the housing. The clamping part is configured to clamp a power conversion device. The fixed connection part is connected to a reactor. The temperature acquisition device is arranged close to the connector, and is configured to acquire a temperature at an overlapping point of the power conversion device and the clamping part. In the present disclosure, quick plug-in and plug-out of the copper bar of the power conversion device is realized by using the clamping part of the connector, so that the power conversion device can be quickly disassembled, reducing maintenance costs and downtime, thereby improving the efficiency of maintaining the power conversion device. With the temperature acquisition device, the temperature at the overlapping position of the clamping part of the connector and the copper bar of the inverter is monitored in real time, so that intervention is performed before a failure of the plug-in device caused by overheating at the overlapping position.

## Description

### FIELD

The present disclosure relates to the technical field of inverters, in particular to a plug-in device and a power conversion apparatus.

### BACKGROUND

As a power conversion apparatus, the inverter includes an inverter module (including a radiator and an insulated gate bipolar transistor (IGBT)) and a reactor. The inverter module and the reactor are connected in two ways. In a first way, the inverter module and the reactor are connected with copper bars that are overlapped by using fastening components, such as screws and bolts. Overlapping faces of the copper bars are tightly connected together, so that the contact resistance is small, almost not causing overheating due to a high contact resistance. However, in the first way, there is a shortcoming, that is, the efficiency of disassembling the IGBT module is low. In order to improve the efficiency of maintaining the inverter, reduce the maintenance cost and reduce the downtime, in a second way, a plug-in unit is arranged at an overlapping position of three-phase alternative current copper bars. Theoretically, due to the arrangement of the plug-in unit, the copper bars are overlapped from screw connection to floating connection (which affects a contact area between conductors), the resistance at the overlapping position of the copper bars is greater than the resistance in the conventional screw connection, increasing the risk of overheating at a position where the copper bars are inserted and unplugged, then reducing the current carrying capacity of the copper bars due to the overheating of power copper bars, and thereby affecting the operation efficiency of a power inverter module.

### SUMMARY

According to the present disclosure, a plug-in device and a power conversion apparatus are provided, to reduce the downtime maintenance cost of an inverter and ensure the operation reliability of a power conversion device.

To achieve the above objectives, a plug-in device is provided according to the present disclosure. The plug-in device includes a housing, a connector and a temperature acquisition device. The housing is defined with a holding cavity. The connector includes a clamping part and a fixed connection part. The clamping part is arranged in the holding cavity. The fixed connection part partially extends out of the housing. The clamping part is configured to clamp a power conversion device. The fixed connection part is configured to connect to a first copper bar. The temperature acquisition device is arranged close to the connector, and is configured to acquire a temperature at an overlapping position of the power conversion device at which the clamping part clamps the power conversion device.

In an embodiment, the fixed connection part includes a first soft connector and a second soft connector. The clamping part is formed by an end of the first soft connector and an end of the second soft connector. The fixed connection part for connecting to the first copper bar is formed by another end of the first soft connector and another end of the second soft connector. The temperature acquisition device is arranged on the first copper bar.

In an embodiment, the plug-in device further includes a fastener. The connector includes a first soft connector and a second soft connector. Each of the first soft connector and the second soft connector is defined with a fixing hole for the fastener to pass through. The first soft connector and the second soft connector are fixedly connected to the first copper bar by using the fastener. The temperature acquisition device is arranged on the fastener.

In an embodiment, the temperature acquisition device is arranged on an end of the housing close to the fixed connection part.

In an embodiment, a mounting hole is defined on an output end of the housing, and the temperature acquisition device is fixed in the mounting hole.

In an embodiment, the temperature acquisition device includes a temperature sensor and a data processing unit. An output terminal of the temperature sensor is connected to an input terminal of the data processing unit, and an output terminal of the data processing unit is connected to the power conversion device. The temperature sensor is configured to convert an acquired temperature parameter to an analog voltage signal. The data processing unit is configured to convert the analog voltage signal to a digital voltage signal.

In an embodiment, the temperature sensor is one of or a combination of a metal temperature device, a positive temperature coefficient thermistor, a negative temperature coefficient thermistor, a thermistor PT100, a PN junction temperature sensor, and a thermocouple.

In an embodiment, a plane area of the clamping part is greater than a cross-sectional area of a copper bar of the power conversion device.

A power conversion apparatus is further provided according to the present disclosure. The power conversion apparatus includes: a power conversion device, a reactor, and the plug-in device.

In an embodiment, the power conversion device includes: a radiator, a power module, and a controller. The controller is connected to the temperature acquisition device of the plug-in device, and is configured to control the radiator and/or the power module to operate based on a temperature detected by the temperature acquisition device.

In the present disclosure, quick plug-in and plug-out of the copper bar of the power conversion device is performed by using the clamping part of the connector, so that the power conversion device can be quickly disassembled, reducing maintenance costs and downtime, thereby improving the efficiency of maintaining the power conversion device. With the temperature acquisition device, the temperature at the overlapping position of the clamping part of the connector and the copper bar of the inverter is monitored in real time, and the acquired temperature parameter is converted to a digital voltage signal, and then the digital voltage signal is outputted to the power conversion device. The power conversion device controls the radiator to operate based on the received digital voltage signal. Thus, intervention is performed before a failure of the plug-in device caused by overheating at the overlapping position, ensuring the safe operation of the power conversion device. With the present disclosure, the downtime maintenance cost of the inverter is reduced, and the operation reliability of the power conversion device is ensured.

### BRIEF DESCRIPTION OF THE DRAWINGS

In order to more clearly explain the technical solutions in the embodiments of the present disclosure or in the conventional technology, the drawings used in description of the embodiments or the conventional technology will be briefly introduced hereinafter. It is apparent that the drawings in the following description only illustrate some embodiments of the present disclosure. Other drawings can be obtained by those skilled in the art without creative efforts based on the structure shown in these drawings.
Figure 1 is a schematic structural diagram of a plug-in device from one perspective according to the present disclosure;
Figure 2 is a schematic structural diagram of a plug-in device from another perspective according to the present disclosure;
Figure 3 is a front view of a plug-in device according to the present disclosure;
Figure 4 is a top view of the plug-in device shown in Figure 3;
Figure 5 is a right view of the plug-in device shown in Figure 3;
Figure 6 is a left view of the plug-in device shown in Figure 3;
Figure 7 is a schematic diagram showing an arrangement position of a temperature acquisition device according to an embodiment of the present disclosure;
Figure 8 is a schematic diagram showing an arrangement position of a temperature acquisition device according to an embodiment of the present disclosure;
Figure 9 is a schematic diagram showing an arrangement position of a temperature acquisition device according to another embodiment of the present disclosure;
Figure 10 is a schematic diagram showing an arrangement position of a temperature acquisition device according to another embodiment of the present disclosure; and
Figure 11 is a schematic structural diagram of a power conversion apparatus according to an embodiment of the present disclosure.

Reference numerals are listed in following table:

| Reference numeral | Name | Reference numeral | Name |
|---|---|---|---|
| 10 | housing | 100 | power conversion device |
| 20 | connector | 200 | reactor |
| 30 | temperature acquisition device | 300 | plug-in device |
| 21 | first soft connector | 110 | radiator |
| 22 | second soft connector | 120 | power module |
| 40 | fastener | 130 | controller |

The object realization, functional features and advantages of the present disclosure will be further described with reference to the attached drawings and in combination with the embodiments.

### DETAILED DESCRIPTION OF THE EMBODIMENTS

The technical solutions according to the embodiments of the present disclosure will be described clearly and completely as follows in conjunction with the drawings in the embodiments of the present disclosure. It is apparent that the described embodiments are only a part of the embodiments according to the present disclosure, rather than all of the embodiments. All other embodiments obtained by those skilled in the art without creative efforts based on the embodiments of the present disclosure shall fall within the protection scope of the present disclosure.

It should be noted that all directional indications (such as up, down, left, right, front, and back) in the embodiments of the present disclosure are only used to explain the relative position relationship between components and movements of the components in a specific posture (as shown in the Figures). If the specific posture changes, the directional indications change accordingly.

In addition, in the present disclosure, the terms, such as "first" and "second", are only used for descriptive purposes, and should not be understood as indicating or implying the relative importance or implicitly indicating the number of indicated technical features. Therefore, the features defined with "first", "second" or the like may include at least one of the features explicitly or implicitly. In addition, the technical solutions between the various embodiments can be combined with each other, but the combination should be based on the realization by those skilled in the art. When the combination of technical solutions is contradictory or cannot be realized, it should be considered that the combination of technical solutions does not exist, and is not within the protection scope of the present disclosure.

A plug-in device is provided according to the present disclosure. The plug-in device is applied to a power conversion apparatus. The power conversion apparatus includes a power conversion device and a reactor, and the power conversion device and the reactor are connected in a pluggable manner by using the plug-in device according to the present disclosure. In the conventional technology, the connection/disassembly of the reactor and the power conversion device is performed by using a plug-in unit rather than using copper bars and screws which are overlapped together. The plug-in unit is fixedly connected with the reactor. The power conversion device is electrically connected to the reactor by inserting a copper bar into a plug-in slot of the plug-in unit. When it is required to disconnect the power conversion device and the reactor, the copper bar of the power conversion device is pulled out of the plug-in slot. In the conventional technology, the connector of the plug-in unit is usually a copper bar, and the copper bar is overlapped with the copper bar of the power conversion device. A gap may exist between the overlapped copper bars. In addition, under the condition of meeting the space and safety regulations, overcurrent areas of the copper bar of the power conversion device and the copper bar of the plug-in unit are limited. In a case that the overlapping region of the copper bar of the power conversion device and the copper bar of the plug-in unit fluctuates, there is a risk of overheating at the overlapping region.

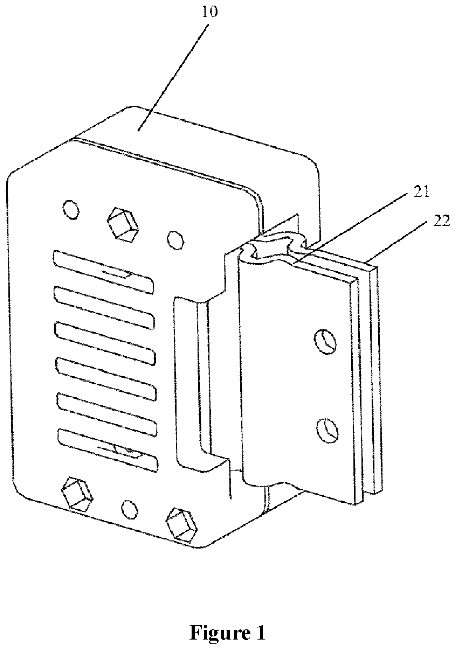

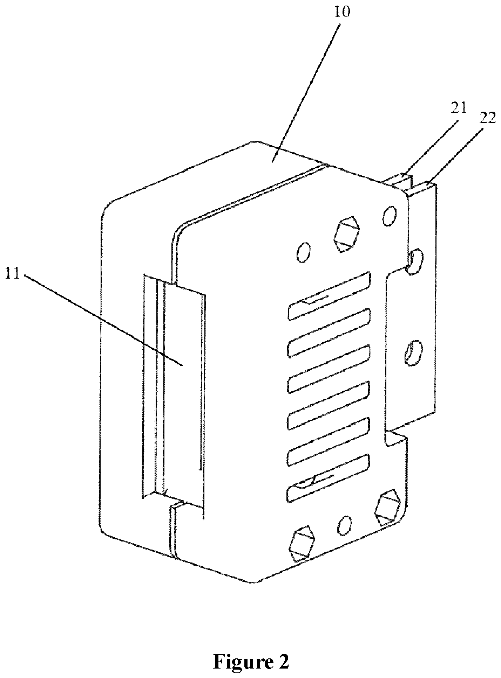

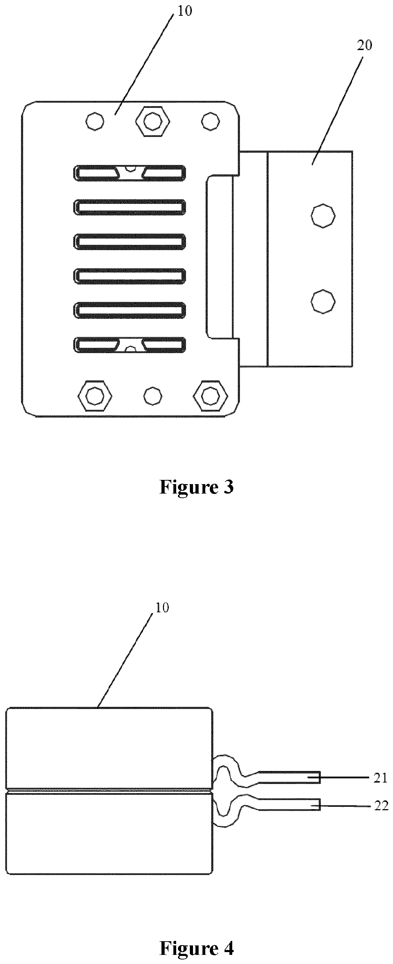

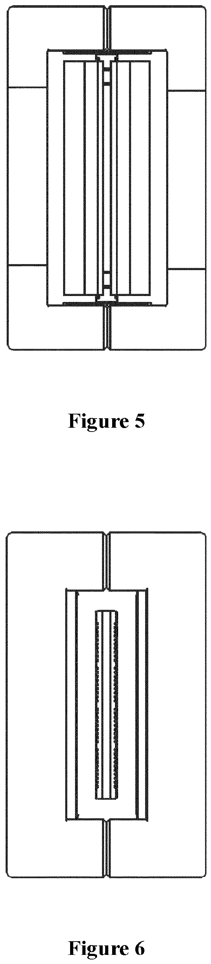

In order to solve the above problems, with reference to Figures 1 to 6, a plug-in device is provided according to the present disclosure. In an embodiment of the present disclosure, the plug-in device includes: a housing 10, a connector 20, and a temperature acquisition device 30.

The housing 10 is defined with a holding cavity.

The connector 20 includes a clamping part and a fixed connection part. The clamping portion is arranged in the holding cavity. The fixed connection part partially extends out of the housing 10. The clamping part is configured to clamp a power conversion device. The fixed connection part is connected to a first copper bar. The power conversion device may be an inverter module, and the first copper bar may be a copper bar of a reactor.

The temperature acquisition device 30 is arranged close to the connector 20, and is configured to acquire a temperature at an overlapping point of the power conversion device and the clamping part.

The clamping part of the connector 20 is connected to the copper bar of the power conversion device, and the fixed connection part of the connector 20 is fixedly connected to the first copper bar. To ensure the reliability of the connection, the fixed connection part of the connector 20 is fixedly connected to the first copper bar by using a fastener 40 such as a screw and a nut, to reduce the overheating caused by increased contact resistance due to the floating of the connection region of the connector 20 and the first copper bar. Figure 1 only shows one of three-phase alternate current outputs. The other two of the three-phase alternate current outputs is similar to the one of the three-phase alternate current outputs, and are not repeated herein.

The power conversion device includes a radiator. In a case that the clamping part of the connector 20 is connected to the copper bar of the power conversion device, the plug-in device is located at an air duct of the radiator. During the operation of the power conversion device, the heat at a temperature of T1 at the overlapping point of the copper bar of the power conversion device and the clamping part of the connector 20 is transferred to a temperature detection point of the temperature acquisition device 30 due to the heat conduction of the connector 20. Due to heat loss in the heat conduction, a temperature parameter T2 actually detected by the temperature acquisition device 30 is equal to T1+t, which is lower than the temperature T1 at the overlapping point. The temperature parameter T2 is converted to a digital voltage signal, and then the digital voltage signal is outputted to the power conversion device. When the temperature corresponding to the digital voltage signal received by the power conversion device is greater than or equal to a first predetermined temperature, it indicates that the temperature T1 at the overlapping point of the copper bar of the power conversion device and the clamping part of the connector 20 is too high, the current carrying capacity of the copper bar of the power conversion device may be reduced, and the operation efficiency of the power conversion device may be affected, then the radiator in the power conversion device is controlled for heat dissipation. When the temperature corresponding to the digital voltage signal received by the power conversion device is greater than or equal to a second predetermined temperature, it indicates that the temperature T1 at the overlapping point of the copper bar of the power conversion device and the clamping part of the connector 20 has reached a critical temperature for the failure of the plug-in device, then the power conversion device stops operating. When the temperature corresponding to the digital voltage signal received by the power conversion device is less than a third predetermined temperature, it indicates that the temperature T1 at the overlapping point of the copper bar of the power conversion device and the clamping part of the connector 20 has restored to a normal temperature, then the radiator in the power conversion device is controlled to stop operating to reduce energy consumption. The third predetermined temperature is less than the first predetermined temperature, and the first predetermined temperature is less than the second predetermined temperature.

Since the heat at temperature T1 at the overlapping point is lost during heat conduction, the temperature parameter T2 (which is equal to T1+t) detected by the temperature acquisition device 30 is less than an actual temperature at the overlapping point of the clamping part of the connector 20 and the copper bar of the inverter. The temperature difference between the detected temperature and the actual temperature is t. Therefore, the first predetermined temperature, the second predetermined temperature and the third predetermined temperature should be set lower than a theoretical temperature. For example, in theory, when the temperature at the overlapping point is greater than or equal to T3+t, the radiator is controlled to dissipate heat, then the third predetermined temperature should be set as T3; when the temperature at the overlapping point is greater than or equal to T4+t, the power conversion device stops operating, then the third predetermined temperature should be set as T4; and when the temperature at the overlapping point is less than T5+t, the radiator is controlled to stop operating, then the third predetermined temperature should be set as T5.

In the present disclosure, quick pull-in and plug-out of the copper bar of the power conversion device is performed by using the clamping part of the connector, so that the power conversion device can be quickly disassembled, reducing the maintenance costs and downtime, thereby improving the efficiency of maintaining the power conversion device. With the temperature acquisition device, the temperature at the overlapping position of the clamping part of the connector and the copper bar of the inverter is monitored in real time, and the acquired temperature parameter is converted to a digital voltage signal, and then the digital voltage signal is outputted to the power conversion device. The power conversion device controls the radiator to operate based on the received digital voltage signal. Thus, intervention is performed before a failure of the plug-in device caused by overheating at the overlapping position, ensuring the safe operation of the power conversion device. With the present disclosure, the downtime maintenance cost of the inverter is reduced, and the operation reliability of the power conversion device is ensured.

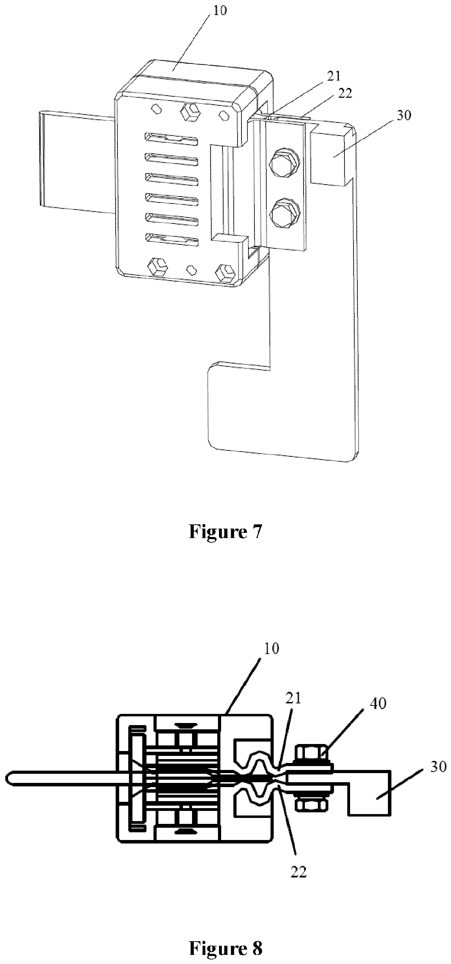

Referring to Figures 7 to 8, in an embodiment, the fixed connection part includes a first soft connector 21 and a second soft connector 22. The clamping part is formed by an end of the first soft connector 21 and an end of the second soft connector 22. The fixed connection part for connecting to the first copper bar is formed by another end of the first soft connector 21 and another end of the second soft connector 22.

The temperature acquisition device 30 is arranged on the first copper bar.

In a case that the connector 20 is overlapped with the copper bar of the power conversion device through a copper bar or other hard metals, the copper bar or the other hard metals cannot fully fitted with the copper bar of the power conversion device, a gap between the copper bar or the other hard metals and the copper bar of the power conversion device exists. Thus, the overlapping between the clamping part of connector 20 and the first copper bar is not in an ideal state, a thermal resistance is generated by force caused in performing plugging-in or plugging-out, and the temperature detected by the temperature acquisition device 30 higher than the actual temperature, affecting the detection accuracy. In the embodiment, the power conversion device is overlapped with the copper bar of the inverter by using a connector 20. After the copper bar of the power conversion device is plugged in, the first soft connector 21 and the second soft connector 22 completely cover the copper bar of the power conversion device, avoiding affecting the detection accuracy of the temperature acquisition device 30 due to the gap.

In the embodiment, the temperature acquisition device 30 is arranged on the first copper bar. The heat at the overlapping point of the clamping part of the connector 20 and the copper bar of the inverter is transferred to a temperature detection point of the temperature acquisition device 30 due to the heat conduction of the connector 20 and the first copper bar. The temperature acquisition device 30 indirectly detects the temperature at the overlapping point of the clamping part of the connector 20 and the copper bar of the inverter by detecting the temperature of the first copper bar.

The first copper bar is fixedly connected to the fixed connection part of the connector 20. The temperature acquisition device 30 is fixedly arranged on the first copper bar, and is electrically connected to the power conversion device through a wire line. The temperature acquisition device 30 is fixedly arranged and is not disassembled frequently. Thus, the temperature acquisition device 30 is not to be damaged due to frequent disassemble, not causing poor contact between the temperature sensor and the power conversion device. If the temperature acquisition device 30 is damaged, it is only required to disassemble the temperature acquisition device 30 from the first copper bar for replacement, facilitating disassembly without affecting other devices.

In an embodiment, the plug-in device further includes a fastener 40.

The connector 20 includes a first soft connector 21 and a second soft connector 22. Each of the first soft connector 21 and the second soft connector 22 is defined with a fixing hole for the fastener 40 to pass through. The first soft connector 21 and the second soft connector 22 are fixedly connected to the first copper bar by using the fastener 40.

The temperature acquisition device 30 is arranged on the fastener 40.

In a case that the connector 20 is overlapped with the copper bar of the power conversion device through a copper bar or other hard metals, the copper bar or other hard metals cannot fully fitted with the copper bar of the power conversion device, a gap between the copper bar or the other hard metals and the copper bar of the power conversion device exists. Thus, the overlapping between the clamping part of connector 20 and the first copper bar is not in an ideal state, a thermal resistance is generated by force caused in performing plugging-in or plugging-out, and the temperature detected by the temperature acquisition device 30 higher than the actual temperature, affecting the detection accuracy. In the embodiment, the power conversion device is overlapped with the copper bar of the inverter by using a connector 20. After the copper bar of the power conversion device is plugged in, the first soft connector 21 and the second soft connector 22 completely cover the copper bar of the power conversion device, avoiding affecting the detection accuracy of the temperature acquisition device 30 due to the gap.

The fastener 40 includes a screw and a nut. In the embodiment, the temperature acquisition device 30 is arranged on the fastener 40. The heat at the overlapping point of the clamping part of the connector 20 and the copper bar of the inverter is transferred to a temperature detection point of the temperature acquisition device 30 due to the heat conduction of the connector 20. The temperature acquisition device 30 indirectly detects the temperature at the overlapping point of the clamping part of the connector 20 and the copper bar of the inverter by detecting the temperature of the fastener 40.

The first copper bar is fixedly connected to the fixed connection part of the connector 20 by using the fastener 40. The temperature acquisition device 30 is fixedly arranged on the fastener 40, and is electrically connected to the power conversion device through a wire line. The temperature acquisition device 30 is fixedly arranged and is not disassembled frequently. Thus, the temperature acquisition device 30 is not to be damaged due to frequent disassemble, not causing poor contact between the temperature sensor and the power conversion device. If the temperature acquisition device 30 is damaged, it is only required to disassemble the temperature acquisition device 30 from the first copper bar for replacement, facilitating disassembly without affecting other devices.

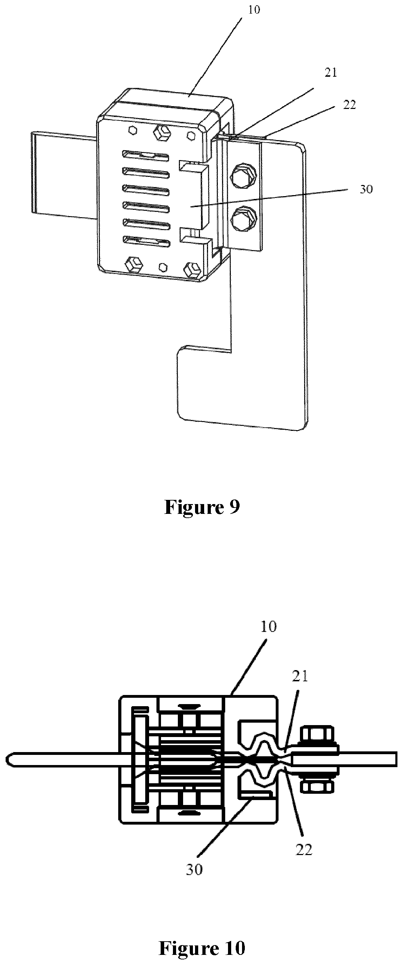

Referring to Figures 9 to 10, in an embodiment, the temperature acquisition device 30 is arranged on an end of the housing 10 close to the fixed connection part.

In the embodiment, the temperature acquisition device 30 is arranged on an end of the housing 10 close to the fixed connection part. The heat at the overlapping point of the clamping part of the connector 20 and the copper bar of the inverter is transferred to the temperature detection point of the temperature acquisition device 30 due to the heat conduction of the connector 20. The temperature acquisition device 30 indirectly detects the temperature at the overlapping point of the clamping part of the connector 20 and the copper bar of the inverter by detecting the temperature of the air around the connector 20.

In the embodiment, the temperature acquisition device 30 is arranged on an end of the housing 10 close to the fixed connection part. Thus, the temperature acquisition device 30 is arranged close to the overlapping point of the copper bar of the power conversion device, and then the detected temperature well reflects the temperature at the overlapping point. In addition, a processing procedure of arranging the temperature acquisition device 30 on the first copper bar is eliminated, thereby reducing the cost.

In an embodiment, a mounting hole is defined on an output end of the housing 10, and the temperature acquisition device 30 is arranged in the housing 10 through the mounting hole.

In the embodiment, a mounting hole is defined on the output end of the housing 10, so that the temperature acquisition device 30 may be conveniently installed/disassembled through the mounting hole, simplifying the installation process of the temperature acquisition device 30.

In an embodiment, the temperature acquisition device 30 is arranged in the holding cavity of the housing 10 close to the clamping part of the connector 20. The temperature acquisition device 30 is arranged integrally with the housing 10. The housing 10 is further defined with a threading hole for a wire line to pass through to connect the temperature acquisition device 30 and the power conversion device. The temperature acquisition device 30 may directly detect the temperature at the clamping part of the connector 20, thereby improving the accuracy of the temperature detection.

In an embodiment, the temperature acquisition device 30 includes a temperature sensor and a data processing unit.

An output terminal of the temperature sensor is connected to an input terminal of the data processing unit, and an output terminal of the data processing unit is connected to the power conversion device.

The temperature sensor is configured to convert an acquired temperature parameter to an analog voltage signal. The data processing unit is configured to convert the analog voltage signal to a digital voltage signal.

The data processing unit includes an amplification circuit and an analog-to-digital conversion circuit. The amplification circuit is configured to amplify an analog voltage signals, and the analog-to-digital conversion circuit is configured to convert a received analog voltage signals to a digital voltage signal.

The temperature sensor converts a detected temperature parameter T2 to an analog voltage signal, and then the analog voltage signal is amplified by using the amplification circuit to be recognized by the power conversion device. The analog-to-digital conversion circuit converts the analog voltage signal to a digital voltage signal, and outputs the digital voltage signal to the power conversion device. The power conversion device converts the received digital voltage signal to a temperature parameter, and compares the temperature parameter with a predetermined temperature. In a case that the temperature parameter corresponding to the digital voltage signal received by the power conversion device is greater than or equal to a first predetermined temperature, the radiator in the power conversion device is controlled for heat dissipation. In a case that the temperature parameter corresponding to the digital voltage signal received by the power conversion device is greater than or equal to a second predetermined temperature, the power conversion device stops operating. In a case that the temperature parameter corresponding to the digital voltage signal received by the power conversion device is less than a third predetermined temperature, the radiator in the power conversion device is controlled to stop operating. The third predetermined temperature is less than the first predetermined temperature, and the first predetermined temperature is less than the second predetermined temperature.

In the embodiment, the temperature sensor monitors the temperature at the overlapping point of the clamping part of the connector 20 and the copper bar of the inverter in real time, and intervention is performed before the failure of the plug-in device due to overheating at the overlapping point, ensuring the safe operation of the power conversion device. The radiator is controlled to stop operating after the temperature at the overlapping point returns to normal, avoiding energy waste.

In an embodiment, the temperature sensor is one of or a combination of a metal temperature device, a positive temperature coefficient thermistor, a negative temperature coefficient thermistor, a thermistor PT100, a PN junction temperature sensor, and a thermocouple. The user may select an appropriate temperature sensor according to an application scenario.

In an embodiment, a plane area of the clamping part is greater than a cross-sectional area of a copper bar of the power conversion device. Specifically, the plane area of the clamping part is greater than three times the cross-sectional area of the copper bar of the power conversion device. Thus, the overheating caused by the increased contact resistance due to the floating connection can be reduced, thereby improving the reliability of the power conversion device in operation.

A power conversion apparatus is further provided according to the present disclosure. The power conversion apparatus includes: a power conversion device 100, a reactor 200, and the plug-in device 300.

The detailed structure of the plug-in device 300 may be referred to the above embodiments, and is not repeated herein. It should be understood that since the plug-in device 300 is used in the power conversion apparatus according to the present disclosure, the embodiments of the power conversion apparatus according to the present disclosure include all the technical solutions in the embodiments of the plug-in device 300, and identical technical effects can be achieved and are not repeated herein.

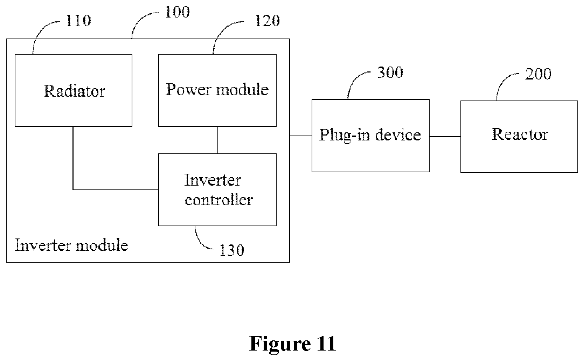

Referring to Figure 11, in an embodiment, the power conversion device 100 includes a radiator 110, a power module 120 and a controller 130.

The controller 130 is connected to the temperature acquisition device 30 of the plug-in device 300. The controller 130 is configured to control the radiator 110 and/or the power module 120 to operate based on a temperature detected by the temperature acquisition device 30.

The radiator 110 may be an air-cooled radiator or a liquid-cooled radiator. In a case that the clamping part of the connector 20 is connected to the copper bar of the power conversion device 100, the plug-in device is located at an air duct of the radiator 110. When the temperature at the overlapping point of the copper bar of the power conversion device and the clamping part of the connector 20 is too high, the power conversion device 100 controls the radiator to operate to cool down the plug-in device. Specifically, when the temperature detected by the temperature acquisition device 30 is greater than or equal to a first predetermined temperature, it indicates that the temperature T1 at the overlapping point of the copper bar of the power conversion device and the clamping part of the connector 20 is too high, the current carrying capacity of the copper bar of the power conversion device may be reduced, and the operation efficiency of the power conversion device may be affected, then the controller 130 controls the radiator 110 for heat dissipation. When the temperature detected by the temperature acquisition device 30 is greater than or equal to a second predetermined temperature, it indicates that the temperature T1 at the overlapping point of the copper bar of the power conversion device and the clamping part of the connector 20 has reached a critical temperature for the failure of the plug-in device, then the controller 130 controls the power module 120 to stop operating. When the temperature corresponding to the digital voltage signal received by the controller 130 is less than a third predetermined temperature, it indicates that the temperature T1 at the overlapping point of the copper bar of the power conversion device and the clamping part of the connector 20 has restored to a normal temperature, then the controller 130 controls the radiator 110 to stop operating to reduce energy consumption. The third predetermined temperature is less than the first predetermined temperature, and the first predetermined temperature is less than the second predetermined temperature.

In the present disclosure, quick plug-in and plug-out of the copper bar of the power conversion device is performed by using the plug-in device, so that the power conversion device can be quickly disassembled, reducing maintenance costs and downtime, thereby improving the efficiency of maintaining the power conversion device. With the temperature acquisition device, the temperature at the overlapping position of the clamping part of the connector and the copper bar of the inverter is monitored in real time, intervention is performed before a failure of the plug-in device caused by overheating at the overlapping position, ensuring the safe operation of the power conversion device. With the present disclosure, the downtime maintenance cost of the inverter is reduced, and the operation reliability of the power conversion device is ensured.

The above embodiments are only preferred embodiments of the present disclosure, and do not limit the scope of the present disclosure. With the inventive concept of the present disclosure, any equivalent structural transformation made by using the contents of description and drawings of the present disclosure, or direct/indirect implementation in other related technical fields, are included in the protection scope of the present disclosure.

## Claims

1. A plug-in device, comprising:
a housing, defined with a holding cavity;
a connector, comprising a clamping part and a fixed connection part, wherein the clamping part is arranged in the holding cavity, the fixed connection part partially extends out of the housing, the clamping part is configured to clamp a power conversion device, and the fixed connection part is connected to a first copper bar; and
a temperature acquisition device, arranged close to the connector and configured to acquire a temperature at an overlapping point of the power conversion device and the clamping part.

2. The plug-in device according to claim 1, wherein
the fixed connection part comprises a first soft connector and a second soft connector, the clamping part is formed by an end of the first soft connector and an end of the second soft connector, and the fixed connection part for connecting to the first copper bar is formed by another end of the first soft connector and another end of the second soft connector; and
the temperature acquisition device is arranged on the first copper bar.

3. The plug-in device according to claim 1, further comprising a fastener, wherein
the connector comprises a first soft connector and a second soft connector, each of the first soft connector and the second soft connector is defined with a fixing hole for the fastener to pass through, and the first soft connector and the second soft connector are fixedly connected to the first copper bar by using the fastener; and
the temperature acquisition device is arranged on the fastener.

4. The plug-in device according to claim 1, wherein the temperature acquisition device is arranged on an end of the housing close to the fixed connection part.

5. The plug-in device according to claim 4, wherein a mounting hole is defined on an output end of the housing, and the temperature acquisition device is arranged in the housing through the mounting hole.

6. The plug-in device according to claim 1, wherein
the temperature acquisition device comprises a temperature sensor and a data processing unit;
an output terminal of the temperature sensor is connected to an input terminal of the data processing unit, and an output terminal of the data processing unit is connected to the power conversion device;
the temperature sensor is configured to convert an acquired temperature parameter to an analog voltage signals; and
the data processing unit is configured to convert the analog voltage signal to a digital voltage signal.

7. The plug-in device according to claim 5, wherein the temperature sensor is one of or a combination of a metal temperature device, a positive temperature coefficient thermistor, a negative temperature coefficient thermistor, a thermistor PT100, a PN junction temperature sensor, and a thermocouple.

8. The plug-in device according to any one of claims 1 to 7, wherein a plane area of the clamping part is greater than a cross-sectional area of a copper bar of the power conversion device.

9. A power conversion apparatus, comprising: a power conversion device, a reactor, and the plug-in device according to any one of claims 1 to 8.

10. The power conversion apparatus according to claim 9, wherein
the power conversion device comprises a radiator, a power module, and a controller; and
the controller is connected to the temperature acquisition device of the plug-in device, and is configured to control the radiator and/or the power module to operate based on a temperature detected by the temperature acquisition device.
